# EUROPEAN PATENT APPLICATION

(11) **EP 2 677 534 A1**
(43) Date of publication of application: **25.12.2013**
(21) Application number: 12746625.8
(22) Date of filing: 13.02.2012
(51) Int. Cl.: H01L 21/20

(54) **COMPOSITE SUBSTRATE WITH PROTECTION FILM AND METHOD OF MANUFACTURING SEMICONDUCTOR DEVICE**

(30) Priority: 15.02.2011 JP 2011029865
(71) Applicant: Sumitomo Electric Industries, Ltd., Osaka-shi, Osaka 541-0041 (JP)
(72) Inventor: SATOH, Issei, Itami-shi Hyogo 664-0016 (JP); YOSHIDA, Hiroaki, Itami-shi Hyogo 664-0016 (JP); YAMAMOTO, Yoshiyuki, Itami-shi Hyogo 664-0016 (JP); HACHIGO, Akihiro, Itami-shi Hyogo 664-0016 (JP); MATSUBARA, Hideki, Itami-shi Hyogo 664-0016 (JP)
(74) Representative: Grünecker, Kinkeldey, Stockmair & Schwanhäusser
(86) International application number: PCT/JP2012/053279
(87) International publication number: WO 2012/111616

(57) **Abstract**

A protective-film-attached composite substrate (2Q) includes a support substrate (10), an oxide film (20) disposed on the support substrate (10), a semiconductor layer (30a) disposed on the oxide film (20), and a protective film (40) protecting the oxide film (20) by covering a portion (20s, 20t) that is a part of the oxide film (20) and covered with none of the support substrate (10) and the semiconductor layer (30a). A method of manufacturing a semiconductor device includes the steps of: preparing the protective-film-attached composite substrate (2Q); and epitaxially growing, on the semiconductor layer (30a) of the protective-film-attached composite substrate (2Q), at least one functional semiconductor layer causing an essential function of a semiconductor device to be performed. Thus, there are provided a protective-film-attached composite substrate having a large effective region where a high-quality functional semiconductor layer can be epitaxially grown, and a method of manufacturing a semiconductor device in which the protective-film-attached composite substrate is used.

## Description

### TECHNICAL FIELD

The present invention relates to a protective-film-attached composite substrate including a support substrate, an oxide film, a semiconductor layer, and a protective film for protecting the oxide film, as well as a method of manufacturing a semiconductor device in which the protective-film-attached composite substrate is used.

### BACKGROUND ART

As a method of manufacturing a composite substrate that is useful for manufacturing semiconductor devices, Japanese Patent Laying-Open Nos. 2007-201429 (PTL 1) and 2007-201430 (PTL 2) for example disclose a method of fabricating a composite substrate including at least one thin insulating layer interposed between a support substrate and an active layer of a semiconductor material.

### CITATION LIST

### PATENT LITERATURE

PTL 1: Japanese Patent Laying-Open No. 2007-201429
PTL 2: Japanese Patent Laying-Open No. 2007-201430

### SUMMARY OF INVENTION

### TECHNICAL PROBLEM

In the composite substrate fabricated by the method disclosed in the above-referenced Japanese Patent Laying-Open Nos. 2007-201429 (PTL 1) and 2007-201430 (PTL 2), an oxide layer is used as the insulating layer. Thus, a resultant problem is decrease of the yield in the case where a group III nitride layer for example is epitaxially grown as another semiconductor layer on the active layer of a semiconductor material of the above-described composite substrate.

The inventors of the present invention have conducted thorough studies on this problem to find why this problem is caused. Specifically, the causes of the problem are found in that: (i) the oxide layer (insulating layer) of the composite substrate has exposed portions which are not covered with the support substrate and the active layer (such portions for example as a side surface portion of the oxide layer that is exposed on the side surface of the composite substrate, and a main surface portion of the oxide layer that is exposed on the main surface of the composite substrate due to absence of the active layer; and (ii) the oxide layer (insulating layer) is corroded under the conditions under which the aforementioned group III nitride layer is epitaxially grown (such conditions for example as a condition of an ambient containing ammonia gas at a temperature on the order of not less than 800°C and not more than 1500°C for the MOCVD (Metal Organic Chemical Vapor Deposition) method, and a condition of an ambient containing a group III nitride gas at a temperature on the order of not less than 800°C and not more than 1500°C for the HVPE (Hydride Vapor Phase Epitaxy)), and particularly corrosion advances significantly from the exposed portions, which are not covered with the support substrate and the active layer and therefore exposed, of the oxide layer.

The inventors of the present invention aim to solve the problem above based on the above findings and accordingly provide a protective-film-attached composite substrate that includes a support substrate, an oxide film, a semiconductor layer, and a protective film for protecting the oxide film, and has a large effective region where a functional semiconductor layer, which causes a function of a semiconductor device to be performed, can be epitaxially grown with high quality, and also provide a method of manufacturing a semiconductor device in which the protective-film-attached composite substrate is used.

### SOLUTION TO PROBLEM

According to an aspect of the present invention, a protective-film-attached composite substrate includes a support substrate, an oxide film disposed on the support substrate, a semiconductor layer disposed on the oxide film, and a protective film protecting the oxide film by covering a portion that is a part of the oxide film and covered with none of the support substrate and the semiconductor layer.

In the protective-film-attached composite substrate according to the present invention, the oxide film may be at least one selected from the group consisting of TiO₂ film, SrTiO₃ film, indium tin oxide film, antimony tin oxide film, ZnO film, and Ga₂O₃ film. At least one of the support substrate and the semiconductor layer may be formed of a group III nitride.

According to another aspect of the present invention, a method of manufacturing a semiconductor device includes the steps of: preparing the above-described protective-film-attached composite substrate; and epitaxially growing, on the semiconductor layer of the protective-film-attached composite substrate, at least one functional semiconductor layer causing an essential function of a semiconductor device to be performed.

### ADVANTAGEOUS EFFECTS OF INVENTION

In accordance with the present invention, there can be provided a protective-film-attached composite substrate that includes a support substrate, an oxide film, a semiconductor layer, and a protective film for protecting the oxide film, and has a large effective region where a functional semiconductor layer, which causes a function of a semiconductor device to be performed, can be epitaxially grown with high quality, as well as a method of manufacturing a semiconductor device in which the protective-film-attached composite substrate is used.

### BRIEF DESCRIPTION OF DRAWINGS

Fig. 1A is a schematic cross section showing an example of the protective-film-attached composite substrate according to the present invention.
Fig. 1B is a schematic cross section showing another example of the protective-film-attached composite substrate according to the present invention.
Fig. 2 is a schematic cross section showing an example of the method of manufacturing a protective-film-attached composite substrate and the method of manufacturing a semiconductor device, according to the present invention.
Fig. 3 is a schematic cross section showing an example of the method of manufacturing a composite substrate.

### DESCRIPTION OF EMBODIMENTS

### [Protective-Film-Attached Composite Substrate]

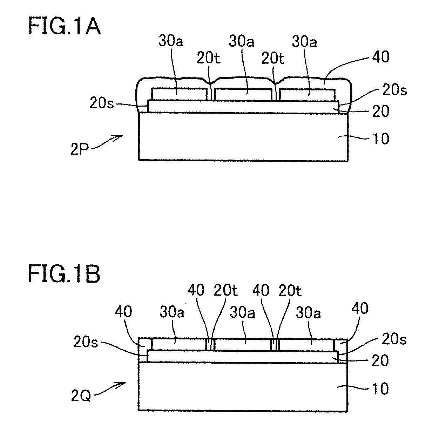

Referring to Figs. 1A and 1B, a protective-film-attached composite substrate 2P, 2Q in an embodiment according to an aspect of the present invention includes a support substrate 10, an oxide film 20 disposed on support substrate 10, a semiconductor layer 30a disposed on oxide film 20, and a protective film 40 protecting oxide film 20 by covering portions 20s, 20t of oxide film 20 that are covered with none of support substrate 10 and semiconductor layer 30a. Here, portions 20s, 20t of oxide film 20 that are covered with none of support substrate 10 and semiconductor layer 30a include, for example, portion 20s that is a side surface of oxide film 20 and covered with none of support substrate 10 and semiconductor layer 30a, and portion 20t that is a part of a main surface of oxide film 20 and covered with none of support substrate 10 and semiconductor layer 30a.

In protective-film-attached composite substrate 2P, 2Q of the present embodiment, portions 20s, 20t that are a part of oxide film 20 and covered with none of support substrate 10 and semiconductor layer 30a are covered with protective film 40, and therefore, the composite substrate has a large effective region where a functional semiconductor layer, which causes an essential function of a semiconductor device to be performed, can be epitaxially grown with high quality on a main surface of semiconductor layer 30a of protective-film-attached composite substrate 2P, 2Q.

Here, protective-film-attached composite substrate 2P shown in Fig. 1A has the form in which protective film 40 also covers a main surface of semiconductor layer 30a in addition to portions 20s, 20t that are a part of oxide film 20 and covered with none of support substrate 10 and semiconductor layer 30a. In the case where a functional semiconductor layer is to be epitaxially grown on semiconductor layer 30a of the protective-film-attached composite substrate, the portion of protective film 40 that covers the main surface of semiconductor layer 30a has to be removed. However, before the functional semiconductor layer is epitaxially grown, protective film 40 can protect not only oxide film 20 but also semiconductor layer 30a.

Protective-film-attached composite substrate 2Q shown in Fig. 1B has the form in which the main surface of semiconductor layer 30a is exposed, which corresponds to protective-film-attached composite substrate 2P shown in Fig. 1A from which the portion of protective film 40 that covers the main surface of semiconductor layer 30a is removed. Protective-film-attached composite substrate 2Q in this form has a large effective region where a high-quality functional semiconductor layer can be epitaxially grown on the main surface of semiconductor layer 30a.

### Support Substrate

Support substrate 10 in protective-film-attached composite substrate 2P, 2Q of the present embodiment is not particularly limited as long as oxide film 20 can be formed on the support substrate, and suitable examples of the support substrate may include sapphire support substrate, Si support substrate, SiC support substrate, group III nitride support substrate, and the like. In particular, support substrate 10 is preferably a group III nitride support substrate formed of a group III nitride which is a semiconductor material, in terms of the fact that respective differences of thermal expansion coefficient and refractive index between the group III nitride support substrate and semiconductor layer 30a are small, there is high compatibility therebetween, and the group III nitride support substrate is electrically conductive. In particular, support substrate 10 is also preferably a sapphire support substrate formed of sapphire which is a transparent material, in terms of low cost and high optical transparency in the case where it is used for an optical device.

Here, in terms of reduction of a difference of thermal expansion coefficient between support substrate 10 and semiconductor layer 30a in protective-film-attached composite substrate 2P, 2Q, support substrate 10 preferably has a chemical composition identical or close to that of semiconductor layer 30a. By way of example, if semiconductor layer 30a is an Si layer, support substrate 10 is preferably an Si support substrate and, if semiconductor layer 30a is a group III nitride layer, support substrate 10 is preferably a group III nitride support substrate.

While support substrate 10 may be a single crystal body, a polycrystalline body such as non-oriented polycrystalline body (sintered body for example) or oriented polycrystalline body, or an amorphous body, support substrate 10 is preferably a polycrystalline body or amorphous body in terms of reduction of the production cost.

The thickness of support substrate 10 is not particularly limited as long as the thickness enables oxide film 20 and semiconductor layer 30a to be supported. In terms of ease of handling, the thickness is preferably 300 µm or more. In terms of reduction of the material cost, the thickness is preferably 1000 µm or less.

### Oxide Film

Oxide film 20 in protective-film-attached composite substrate 2P, 2Q of the present embodiment is not particularly limited as long as semiconductor layer 30a can be formed on oxide film 20, oxide film 20 can be formed on support substrate 10, and oxide film 20 provides a high bonding strength between support substrate 10 and semiconductor layer 30a. Suitable examples of oxide film 20 may include TiO₂ film, SrTiO₃ film, ITO (indium tin oxide) film, ATO (antimony tin oxide) film, ZnO film, Ga₂O₃ film, Al₂O₃ film, and the like. In terms of the following respect, oxide film 20 is preferably at least one selected from the group consisting of TiO₂ film, SrTiO₃ film, ITO film, ATO film, ZnO film, and Ga₂O₃ film. Specifically, in terms of enhancement of optical transparency, oxide film 20 is preferably an oxide film having a high refractive index, for example, is at least one selected from the group consisting of a TiO₂ film (having a refractive index of about 2.8 for the light of 400 nm in wavelength) and an SrTiO₃ film (having a refractive index of about 2.4 for the light of 400 nm in wavelength).

The thickness of oxide film 20 is not particularly limited as long as the thickness increases the bonding strength between support substrate 10 and semiconductor layer 30a. In terms of increase of the bonding strength, the thickness is preferably 50 nm or more. In terms of reduction of the cost for forming the film, the thickness is preferably 1000 nm or less.

### Semiconductor Layer

Semiconductor layer 30a in protective-film-attached composite substrate 2P, 2Q of the present embodiment is not particularly limited as long as a functional semiconductor layer, which causes a function of an intended semiconductor device to be performed, can be epitaxially grown on semiconductor layer 30a. Suitable examples of semiconductor layer 30a may include group III nitride layer, Si layer, and the like. In the case where the intended semiconductor device is an optical device and a group III nitride layer is to be epitaxially grown as the functional semiconductor layer, semiconductor layer 30a is particularly preferably a group III nitride layer formed of a group III nitride having a chemical composition identical or close to that of the functional semiconductor layer, in terms of enhancement of the quality of the functional semiconductor layer.

Support substrate 10 is preferably formed of a group III nitride which is a semiconductor, in terms of the fact that it has electrical conductivity. It is preferable, therefore, at least one of support substrate 10 and semiconductor layer 30a is formed of a group III nitride.

Moreover, in terms of reduction of a difference in thermal expansion coefficient between support substrate 10 and semiconductor layer 30a as described above, semiconductor layer 30a preferably has a chemical composition identical or close to that of support substrate 10. It is therefore preferable that both support substrate 10 and semiconductor layer 30a are formed of a group III nitride.

The thickness of semiconductor layer 30a is not particularly limited as long as the thickness enables a high-quality functional semiconductor layer to be epitaxially grown on semiconductor layer 30a. In terms of formation of semiconductor layer 30a without cracking it, the thickness is preferably 100 nm or more. In terms of maintenance of the quality and the thickness of semiconductor layer 30a with high precision, the thickness is preferably 1000 µm or less.

### Protective Film

Protective film 40 in protective-film-attached composite substrate 2P, 2Q of the present embodiment is not particularly limited as long as protective film 40 protects oxide film 20 by covering portions 20s, 20t of oxide film 20 that are covered with none of support substrate 10 and semiconductor layer 30a.

In terms of protection of oxide film 20, protective film 40 is preferably a film having high heat resistance and high corrosion resistance under the conditions under which a functional semiconductor layer is epitaxially grown on semiconductor layer 30a. Preferred heat resistance and corrosion resistance of protective film 40 mean, for example, that protective film 40 has heat resistance and corrosion resistance in an ambient containing ammonia gas at a temperature of not less than 800°C and not more than 1500°C and a partial pressure of not less than 1 kPa and not more than 100 kPa in the case where the method for epitaxially growing a group III nitride layer as the functional semiconductor layer on semiconductor layer 30a is the MOCVD (Metal Organic Chemical Vapor Deposition) method. It also means that protective film 40 has heat resistance and corrosion resistance in an ambient containing group III chloride gas at a temperature of not less than 800°C and not more than 1500°C and a partial pressure of not less than 1 kPa and not more than 100 kPa in the case where the method for epitaxially growing a group III nitride layer as the functional semiconductor layer on semiconductor layer 30a is the HVPE (Hydride Vapor Phase Epitaxy) method.

In terms of the aim of ensuring that protective film 40 covers portions 20s, 20t of oxide film 20 that are covered with none of support substrate 10 and semiconductor layer 30a and that protective film 40 is not separated from these portions, protective film 40 preferably has a high strength of bonding to at least one of support substrate 10, oxide film 20, and semiconductor layer 30a, and has a thermal expansion coefficient identical or close to that of at least one of support substrate 10, oxide film 20, and semiconductor layer 30a. In this respect, a difference between the thermal expansion coefficient of protective film 40 and the thermal expansion coefficient of at least one of support substrate 10, oxide film 20, and semiconductor layer 30a is preferably 3×0⁻⁶°C⁻¹ or less.

In terms of the above respects, protective film 40 is preferably formed of at least one of those such as group III nitride (compound made up of group III element and nitrogen, for example, InₓAl_{y}Ga_{1-x-y}N (0≤x, 0≤y, x+y≤1)), mullite (aluminosilicate mineral having a single chain structure, expressed by a chemical formula 3Al₂O₃ 2SiO₂ - 2Al₂O₃ · SiO₂ or Al₆O₁₃Si₂), silicon (Si), molybdenum (Mo), and the like.

The thickness of protective film 40 is not particularly limited as long as the thickness is sufficient for protecting oxide film 20. In terms of enhancement of protection of oxide film 20, the thickness is preferably 10 nm or more. In terms of reduction of the amount of light absorbed in oxide film 20 and reduction of the cost for forming the film, the thickness is preferably 500 nm or less.

As shown in Fig. 1B, it is preferable for protective-film-attached composite substrate 2Q that the main surface of semiconductor layer 30a is exposed. On the exposed main surface of semiconductor layer 30a of protective-film-attached composite substrate 2Q, a functional semiconductor layer, which causes a function of an intended semiconductor device to be performed, can easily be epitaxially grown.

### [Method of Manufacturing Protective-Film-Attached Composite Substrate]

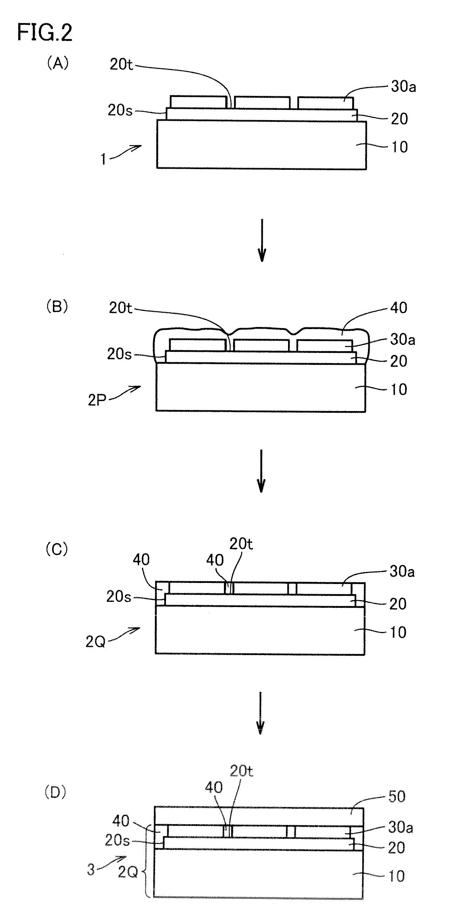

Referring to Fig. 2, a method of manufacturing protective-film-attached composite substrate 2P, 2Q of the present embodiment may include the step (Fig. 2 (A)) of preparing a composite substrate 1 including support substrate 10, oxide film 20, and semiconductor layer 30a, the step (Fig. 2 (B)) of forming protective film 40 on composite substrate I to thereby obtain protective-film-attached composite substrate 2P, and the step (Fig. 2 (C)) of processing protective-film-attached composite substrate 2P to remove a portion of protective film 40 that covers a main surface of semiconductor layer 30a and thus obtain protective-film-attached composite substrate 2Q in which the main surface of semiconductor layer 30a is exposed.

Through the steps above, protective-film-attached composite substrate 2P, 2Q can efficiently be manufactured by which a functional semiconductor layer of high quality can epitaxially be grown on the main surface of semiconductor layer 30a.

### Step of Preparing Composite Substrate 1

Referring to Fig. 2 (A), the method of manufacturing protective-film-attached composite substrate 2P, 2Q of the present embodiment may include the step of preparing composite substrate 1 including support substrate 10, oxide film 20, and semiconductor layer 30a (step of preparing composite substrate 1).

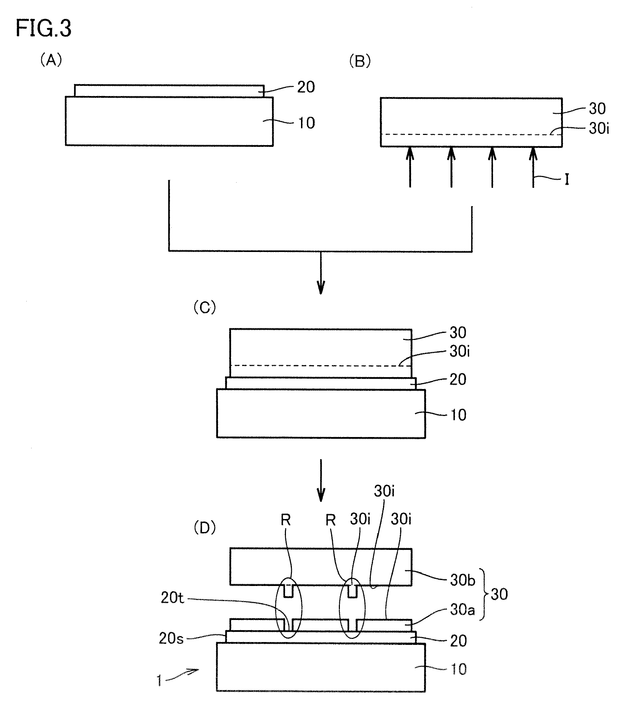

Here, referring to Fig. 3, the step of preparing composite substrate 1 is not particularly limited. In terms of efficient preparation of composite substrate 1, the step may include the sub step (Fig. 3 (A)) of preparing support substrate 10, the sub step (Fig. 3 (A)) of forming oxide film 20 on a main surface of support substrate 10, the sub step (Fig. 3 (B)) of implanting ions I to a region of a certain depth from one main surface of a semiconductor substrate 30, the sub step (Fig. 3 (C)) of bonding the main surface, on the ion implantation region 30i (region where ions I are implanted) side, of semiconductor substrate 30, to a main surface of oxide film 20 formed on the main surface of support substrate 10, and the sub step (Fig. 3 (D)) of separating semiconductor substrate 30 along ion implantation region 30i into semiconductor layer 30a and a remaining semiconductor substrate 30b, to form semiconductor layer 30a on the main surface of oxide film 20 formed on the main surface of support substrate 10.

Referring to Fig. 3 (A), in the sub step of preparing support substrate 10, support substrate 10 may be prepared by a common method suitable for the material and the shape of support substrate 10. For example, a group III nitride support substrate may be prepared by processing a group III nitride crystal body obtained by a vapor phase method such as HVPE (Hydride Vapor Phase Epitaxy) method or sublimation method, or a liquid phase method such as flux growth method or high nitrogen pressure solution growth method, into a predetermined shape. A sapphire support substrate may be prepared by processing a sapphire crystal body into a predetermined shape.

In the sub step shown in Fig. 3 (A) of forming oxide film 20 on support substrate 10, the method of forming oxide film 20 on the main surface of support substrate 10 is not particularly limited as long as the method is suitable for formation of the oxide film. As this method, any of common methods such as sputtering method, pulsed laser deposition method, molecular beam epitaxy method, electron beam deposition method, and chemical vapor deposition method may be used.

In the sub step shown in Fig. 3 (B) of implanting ions I in a region of a certain depth from one main surface of semiconductor substrate 30, while the depth to which ions I are implanted is not particularly limited, the depth is preferably not less than 100 nm and not more than 1000 µm. If the depth to which ions I are implanted is smaller than 100 nm, semiconductor layer 30a, which is formed by separating semiconductor substrate 30 along this ion implantation region 30i is likely to be cracked. If the depth is larger than 1000 µm, ions distribute over a large area, which makes it difficult to adjust the depth at which the semiconductor substrate is separated and thus makes it difficult to adjust the thickness of semiconductor layer 30a. The type of ions to be implanted is not particularly limited. In terms of suppression of degradation in quality of the semiconductor layer to be formed, ions of a small mass are preferred. For example, hydrogen ions, helium ions or the like are preferred. Ion implantation region 30i thus formed is embrittled due to the implanted ions.

In the sub step shown in Fig. 3 (C) of bonding the main surface on the ion implantation region 30i side of semiconductor substrate 30, onto the main surface of oxide film 20 formed on the main surface of support substrate 10, the method of bonding them to each other is not particularly limited. In terms of the capability of keeping the bonding strength even in a high-temperature ambient after they are bonded together, preferred methods may be direct joint method by which the surfaces to be bonded to each other are cleaned and directly bonded to each other, and thereafter the temperature is raised to a temperature on the order of 600°C to 1200°C so that they are joined together, surface activation method by which the surfaces to be bonded to each other are activated by plasma, ions or the like and they are joined together at a low temperature on the order of room temperature (for example, 25°C) to 400°C, and the like.

In the sub step shown in Fig. 3 (D) of separating semiconductor substrate 30 along ion implantation region 30i into semiconductor layer 30a and remaining semiconductor substrate 30b, to form semiconductor layer 30a on the main surface of oxide film 20 formed on the main surface of support substrate 10, the method of separating semiconductor substrate 30 along its ion implantation region 30i is not particularly limited as long as the method applies certain energy to ion implantation region 30i of semiconductor substrate 30. As this method, at least one method among the method applying stress, the method applying heat, the method applying light, and the method applying ultrasonic wave may be used. Since ion implantation region 30i has been embrittled due to the implanted ions, semiconductor substrate 30 to which the above-described energy is applied is readily separated into semiconductor layer 30a bonded onto oxide film 20 formed on the main surface of support substrate 10, and remaining semiconductor substrate 30b.

In the manner described above, semiconductor layer 30a is formed on the main surface of oxide film 20 formed on the main surface of support substrate 10, and accordingly composite substrate 1 is obtained that includes support substrate 10, oxide film 20 formed on the main surface of support substrate 10, and semiconductor layer 30a formed on the main surface of oxide film 20.

Referring to Fig. 3 (D), composite substrate 1 thus obtained has portion 20s which is a side surface of oxide film 20 and covered with none of support substrate 10 and semiconductor layer 30a. In the sub steps described above, there could be a malfunction when oxide film 20 is formed, a malfunction when ions are implanted to semiconductor substrate 30, a malfunction when oxide film 20 and semiconductor substrate 30 are bonded to each other, or the like, which could cause, when semiconductor substrate 30 is separated into semiconductor layer 30a and remaining semiconductor substrate 30b, an abnormal separation region R where the semiconductor substrate is not separated along ion implantation region 30i but separated along the interface between semiconductor substrate 30 and oxide film 20. In abnormal separation region R of composite substrate 1, portion 20t is left which is a part of the main surface of oxide film 20 and covered with none of support substrate 10 and semiconductor layer 30a.

Above-described composite substrate 1 having portions 20s, 20t that are a part of oxide film 20 and covered with none of support substrate 10 and semiconductor layer 30a is insufficient in terms of the heat resistance and the corrosion resistance of oxide film 20 under the conditions under which a functional semiconductor layer is epitaxially grown on the main surface of semiconductor layer 30a. Therefore, corrosion advances significantly from portions 20s, 20t which are a part of oxide film 20 and covered with none of support substrate 10 and semiconductor layer 30a, resulting in a problem of reduction of the effective region where a functional semiconductor layer is to be epitaxially grown to manufacture a semiconductor device.

Referring to Fig. 2 (B) to Fig. 2 (C), protective-film-attached composite substrate 2P, 2Q is manufactured through the steps described below in order to solve the above problem.

### Step of Obtaining Protective-Film-Attached Composite Substrate 2P

Referring to Fig. 2 (B), the method of manufacturing protective-film-attached composite substrate 2P, 2Q of the present embodiment may include the step of forming protective film 40 on composite substrate 1 to thereby obtain protective-film-attached composite substrate 2P.

In the step of obtaining protective-film-attached composite substrate 2P, the method of forming protective film 40 on composite substrate 1 is not particularly limited as long as the method can be used to cover portions 20s, 20t that are a part of oxide film 20 and covered with none of support substrate 10 and semiconductor layer 30a. As this method, any of common methods such as sputtering method, pulsed laser deposition method, molecular beam epitaxy method, electron beam deposition method, chemical vapor deposition method, sol-gel method, and like may be used.

Protective-film-attached composite substrate 2P thus obtained has the form in which, in addition to portions 20s, 20t which are a part of oxide film 20 and covered with none of support substrate 10 and semiconductor layer 30a, the main surface of semiconductor layer 30a is covered with protective film 40. Therefore, prior to epitaxial growth of a functional semiconductor layer, this protective film 40 can protect not only oxide film 20 but also semiconductor layer 30a.

### Step of Obtaining Protective-Film-Attached Composite Substrate 2Q

Referring to Fig. 2 (C), the method of manufacturing protective-film-attached composite substrate 2Q of the present embodiment may include the step of processing protective-film-attached composite substrate 2P to remove the portion of protective film 40 that covers the main surface of semiconductor layer 30a and thus obtain protective-film-attached composite substrate 2Q in which the main surface of semiconductor layer 30a is exposed.

In the step of obtaining protective-film-attached composite substrate 2Q, the method of processing protective-film-attached composite substrate 2P to remove the portion that is a part of protective film 40 and covers the main surface of semiconductor layer 30a is not particularly limited. As this method, any of common methods such as dry etching like RIE (Reactive Ion Etching), wet etching using acid solution, alkaline solution, or the like, grinding, mechanical polishing, chemical-mechanical polishing, chemical polishing, and the like may be used.

In protective-film-attached composite substrate 2Q thus obtained, portions 20s, 20t that are a part of oxide film 20 and covered with none of support substrate 10 and semiconductor layer 30a are covered with protective film 40 and the main surface of semiconductor layer 30a is exposed, and therefore, a large effective region is provided where a high-quality functional semiconductor layer can epitaxially be grown on the main surface of semiconductor layer 30a.

Namely, referring to Fig. 2 (D), protective-film-attached composite substrate 2Q obtained through the above-described manufacturing method, to which the step of epitaxially growing functional semiconductor layer 50 on the main surface of semiconductor layer 30a is added, has a large effective region where the functional semiconductor layer of high quality can epitaxially be grown. Therefore, semiconductor devices having excellent characteristics can be manufactured at a high yield ratio.

### [Method of Manufacturing Semiconductor Device]

Referring to Fig. 2, a method of manufacturing a semiconductor device in an embodiment according to another aspect of the present invention is a method of manufacturing a semiconductor device including: the step (Fig. 2 (A) to Fig. 2 (C)) of preparing protective-film-attached composite substrate 2Q as described above; and the step (Fig. 2 (D)) of epitaxially growing, on semiconductor layer 30a of protective-film-attached composite substrate 2Q, at least one functional semiconductor layer 50 causing an essential function of a semiconductor device 3 to be performed.

In accordance with the method of manufacturing a semiconductor device of the present embodiment, protective-film-attached composite substrate 2Q is prepared in which support substrate 10, oxide film 20, semiconductor layer 30a, and protective film 40 are included and portions 20s, 20t that are a part of oxide film 20 and covered with none of support substrate 10 and semiconductor layer 30a are covered with protective film 40, and at least one functional semiconductor layer 50 is epitaxially grown on semiconductor layer 30a of this protective-film-attached composite substrate 2Q. Accordingly, corrosion of the oxide film is suppressed in a high-temperature and highly-corrosive ambient in which epitaxial growth is done, and the functional semiconductor layer of high quality can be grown over the large effective region. Semiconductor devices having excellent characteristics can therefore be manufactured at a high yield ratio.

### Step of Preparing Protective-Film-Attached Composite Substrate

Referring to Fig. 2 (A) to Fig. 2 (C), the method of manufacturing a semiconductor device of the present embodiment includes the step of preparing above-described protective-film-attached composite substrate 2Q. The step of preparing protective-film-attached composite substrate 2Q includes the above-described steps of preparing composite substrate 1, obtaining protective-film-attached composite substrate 2P, and obtaining protective-film-attached composite substrate 2Q, namely is similar to the method of manufacturing protective-film-attached composite substrate 2Q.

### Step of Epitaxially Growing Functional Semiconductor Layer

Referring to Fig. 2 (D), the method of manufacturing a semiconductor device of the present invention includes the step of epitaxially growing, on semiconductor layer 30a of protective-film-attached composite substrate 2Q, at least one functional semiconductor layer 50 causing an essential function of semiconductor device 3 to be performed.

Here, the method of epitaxially growing functional semiconductor layer 50 is not particularly limited. In terms of growth of high-quality functional semiconductor layer 50, vapor phase methods such as MOCVD method, HVPE method, MBE (Molecular Beam Epitaxy) method, and sublimation method, and liquid phase methods such as flux growth method and high nitrogen pressure solution growth method, are preferred.

At least one functional semiconductor layer 50 causing an essential function of semiconductor device 3 to be performed varies depending on the type of the semiconductor device. For example, if the semiconductor device is an optical device, examples of functional semiconductor layer 50 may include a light-emitting layer having an MQW (Multiple Quantum Well) structure. If the semiconductor device is an electronic device, examples of the functional semiconductor layer may include an electron stop layer, an electron drift layer, and the like.

### EXAMPLES

### [Example 1]

### Example 1-1

### 1. Preparation of Support Substrate

Referring to Fig. 3 (A), from a GaN crystal body (not shown) grown by the HVPE method, a substrate having a diameter of 50 mm and a thickness of 500 µm was cut, and the main surface of the substrate was polished. Thus, a GaN support substrate (support substrate 10) was prepared.

### 2. Formation of Oxide Film on Support Substrate

Referring to Fig. 3 (A), the sputtering method was used to grow a TiO₂ film (oxide film 20) having a thickness of 300 nm on the GaN support substrate (support substrate 10).

### 3. Formation of Semiconductor Layer on Oxide Film

Referring to Fig. 3 (B), from a GaN crystal body (not shown) grown by the HVPE method, a substrate having a diameter of 50 mm and a thickness of 500 µm was cut, and the main surface of the substrate was chemically and mechanically polished to prepare a GaN substrate (semiconductor substrate 30). Hydrogen ions were implanted to a depth of 300 nm from one main surface of this substrate.

Referring to Fig. 3 (C), the main surface of the TiO₂ film (oxide film 20) on the GaN support substrate (support substrate 10), and the main surface on the ion-implanted side of the GaN substrate (semiconductor substrate 30) were each cleaned with argon plasma and were thereafter bonded to each other under a bonding pressure of 8 MPa.

Referring to Fig. 3 (D) and Fig. 2(A), the substrates bonded together were heat-treated at 300°C for two hours to thereby increase the bonding strength of the substrates bonded together and also separate the GaN substrate (semiconductor substrate 30) along its ion implantation region 30i. Accordingly, on the TiO₂ film (oxide film 20), a GaN layer (semiconductor layer 30a) having a thickness of 300 nm was formed. Thus, composite substrate 1 in which the GaN support substrate (support substrate 10), the TiO₂ film (oxide film 20), and the GaN layer (semiconductor layer 30a) were formed in this order was obtained.

Obtained composite substrate I was observed with an optical microscope. There were found portion 20s that was a side surface of the TiO₂ film (oxide film 20) and covered with none of the GaN support substrate (support substrate 10) and the GaN layer (semiconductor layer 30a), as well as portion 20t that was a part of the main surface of the TiO₂ film (oxide film 20) and covered with none of support substrate 10 and semiconductor layer 30a.

### 4. Formation of Protective Film

Referring to Fig. 2 (B), on the main surface of composite substrate 1 where the TiO₂ film (oxide film 20) and the GaN layer (semiconductor layer 30a) were formed, a GaN film (protective film 40) having a thickness of 300 nm was formed by the sputtering method to thereby obtain protective-film-attached composite substrate 2P.

The obtained protective-film-attached composite substrate 2P was observed with an optical microscope. It was found that, in addition to portion 20s that was a side surface of the TiO₂ film (oxide film 20) and covered with none of the GaN support substrate (support substrate 10) and the GaN layer (semiconductor layer 30a) and portion 20t that was a part of the main surface of the TiO₂ film (oxide film 20) and covered with none of support substrate 10 and semiconductor layer 30a, the main surface and the side surface of the GaN layer (semiconductor layer 30a) were also covered with the GaN film (protective film 40).

Referring to Fig. 2 (C), in protective-film-attached composite substrate 2P, the portion of protective film 40 that covered the main surface of semiconductor layer 30a was removed by chemical-mechanical polishing (CMP) to expose the main surface of semiconductor layer 30a. Thus, protective-film-attached composite substrate 2Q was obtained.

Obtained protective-film-attached composite substrate 2Q was observed with an optical microscope. It was found that portion 20s that was a side surface of oxide film 20 and covered with none of support substrate 10 and semiconductor layer 30a, as well as portion 20t that was a part of the main surface of oxide film 20 and covered with none of support substrate 10 and semiconductor layer 30a were covered with the GaN film (protective film 40).

### 5. Measurement of Transmittance of Protective-Film-Attached Composite Substrate

The transmittance of protective-film-attached composite substrate 2Q for the light having a wavelength of 500 nm was measured with an ultraviolet and visible spectrophotometer. The measured transmittance was 59.4%.

### 6. Epitaxial Growth of Functional Semiconductor Layer

On the main surface of the GaN layer (semiconductor layer 30a) of protective-film-attached composite substrate 2Q, a GaN layer (functional semiconductor layer 50) of 300 nm in thickness was epitaxially grown by the MOCVD method.

### 7. Measurement of Transmittance of Protective-Film-Attached Composite Substrate after Epitaxial Growth

The transmittance of protective-film-attached composite substrate 2Q on which the GaN layer (functional semiconductor layer 50) had been epitaxially grown in the above-described manner, for the light having a wavelength of 500 nm, was measured with an ultraviolet and visible spectrophotometer. The measured transmittance was 58.8%. The results are summarized in Table 1.

### Example 1-2

Referring to Fig. 2, protective-film-attached composite substrate 2Q as shown in Fig. 2 (C) was obtained in a similar manner to Example 1-1 except that a mullite film having a thickness of 300 µm was formed as protective film 40 by the sputtering method. The transmittance of thus obtained protective-film-attached composite substrate 2Q for the light having a wavelength of 500 nm was measured in a similar manner to Example 1-1. The measured transmittance was 59.4%. On the main surface of the GaN layer (semiconductor layer 30a) of protective-film-attached composite substrate 2Q, a GaN layer (functional semiconductor layer 50) having a thickness of 300 nm was epitaxially grown. The transmittance of protective-film-attached composite substrate 2Q on which the GaN layer (functional semiconductor layer 50) had been epitaxially grown, for the light having a wavelength of 500 run, was measured in a similar manner to Example 1-1. The measured transmittance was 58.8%. The results are summarized in Table 1.

### Example 1-3

Referring to Fig. 2, protective-film-attached composite substrate 2Q as shown in Fig. 2 (C) was obtained in a similar manner to Example 1-1 except that a molybdenum film having a thickness of 300 µm was formed as protective film 40 by the sputtering method. The transmittance of thus obtained protective-film-attached composite substrate 2Q for the light having a wavelength of 500 nm was measured in a similar manner to Example 1-1. The measured transmittance was 59.4%. On the main surface of the GaN layer (semiconductor layer 30a) of protective-film-attached composite substrate 2Q, a GaN layer (functional semiconductor layer 50) having a thickness of 300 nm was epitaxially grown. The transmittance of protective-film-attached composite substrate 2Q on which the GaN layer (functional semiconductor layer 50) had been epitaxially grown, for the light having a wavelength of 500 nm, was measured in a similar manner to Example 1-1. The measured transmittance was 58.8% The results are summarized in Table 1.

### Comparative Example 1

In a similar manner to Example 1-1, composite substrate 1 was obtained. The transmittance of thus obtained composite substrate 1 for the light having a wavelength of 500 nm was measured in a similar manner to Example 1. The measured transmittance was 62 5% On the main surface of the GaN layer (semiconductor layer) of this composite substrate 1, a GaN layer (functional semiconductor layer) having a thickness of 300 nm was epitaxially grown in a similar manner to Example 1-1. The transmittance of composite substrate 1 on which the GaN layer (functional semiconductor layer) had been epitaxially grown, for the light having a wavelength of 500 nm, was measured in a similar manner to Example 1-1. The measured transmittance was 43.8% The results are summarized in Table 1

**Table 1**

| | composite substrate | | | | optical transmittance | |
|---|---|---|---|---|---|---|
| | support substrate | oxide film | semiconductor layer | protective film | before epitaxial growth | after epitaxial growth |
| Example 1-1 | GaN | TiO₂ | GaN | GaN | 59.4 | 58.8 |
| Example 1-2 | GaN | TiO₂ | GaN | mullite | 59.4 | 58.8 |
| Example 1-3 | GaN | TiO₂ | GaN | molybdenum | 59.4 | 58.8 |
| Comparative Example 1 | GaN | TiO₂ | GaN | - | 62.5 | 43 8 |

As clearly seen from Table 1, in contrast to the fact that the optical transmittance of the composite substrate of Comparative Example 1 without protective film was significantly decreased from 62 5% to 43 8% by the epitaxial growth of the functional semiconductor layer, the optical transmittance of respective protective-film-attached composite substrates of Examples 1-1, 1-2, and 1-3 was caused to change from 59.4% to 58 8%, namely exhibit substantially no decrease, even by the epitaxial growth of the functional semiconductor layer. Such a decrease of the optical transmittance of the protective-film-attached composite substrates of Examples 1-1, 1-2, and 1-3 as well as the composite substrate without protective film of Comparative Example 1, resulted from devitrification due to degradation by heat and corrosion of the TiO₂ film (oxide film) when the functional semiconductor layer was epitaxially grown. Namely, it has been found that, in the protective-film-attached composite substrate, the TiO₂ film (oxide film) is protected by one of the GaN film, the mullite film, and the molybdenum film that are each a protective film, and therefore, degradation of the oxide film when the functional semiconductor layer is epitaxially grown is remarkably reduced as compared with the composite substrate without protective film, which allows a large effective region to be maintained, and accordingly, semiconductor devices having excellent characteristics can be obtained at a high yield.

### [Example 2]

### Example 2-1

Referring to Figs. 2 and 3, protective-film-attached composite substrate 2Q as shown in Fig. 2 (C) was obtained in a similar manner to Example 1-1, except that an SrTiO₃ film having a thickness of 300 nm was grown as oxide film 20 by the sputtering method. The transmittance of thus obtained protective-film-attached composite substrate 2Q for the light having a wavelength of 500 nm was measured in a similar manner to Example 1-1. The measured transmittance was 61.1%. On the main surface of the GaN layer (semiconductor layer) of this protective-film-attached composite substrate 2Q, a GaN layer (functional semiconductor layer) having a thickness of 300 nm was epitaxially grown in a similar manner to Example 1-1. The transmittance of protective-film-attached composite substrate 2Q on which the GaN layer (functional semiconductor layer) had been epitaxially grown, for the light having a wavelength of 500 nm, was measured in a similar manner to Example 1-1. The measured transmittance was 60.5%. The results are summarized in Table 2.

### Example 2-2

Referring to Fig. 2, protective-film-attached composite substrate 2Q as shown in Fig. 2 (C) was obtained in a similar manner to Example 2-1 except that a mullite film having a thickness of 300 µm was formed as protective film 40 by the sputtering method. The transmittance of thus obtained protective-film-attached composite substrate 2Q for the light having a wavelength of 500 nm was measured in a similar manner to Example 1-1. The measured transmittance was 61.1%. On the main surface of the GaN layer (semiconductor layer 30a) of protective-film-attached composite substrate 2Q, a GaN layer (functional semiconductor layer 50) having a thickness of 300 nm was epitaxially grown. The transmittance of protective-film-attached composite substrate 2Q on which the GaN layer (functional semiconductor layer 50) had been epitaxially grown, for the light having a wavelength of 500 nm, was measured in a similar manner to Example 1-1. The measured transmittance was 60.5%. The results are summarized in Table 2.

### Example 2-3

Referring to Fig. 2, protective-film-attached composite substrate 2Q as shown in Fig. 2 (C) was obtained in a similar manner to Example 2-1 except that a molybdenum film having a thickness of 300 µm was formed as protective film 40 by the sputtering method. The transmittance of thus obtained protective-film-attached composite substrate 2Q for the light having a wavelength of 500 nm was measured in a similar manner to Example 1-1. The measured transmittance was 61.1%. On the main surface of the GaN layer (semiconductor layer 30a) of protective-film-attached composite substrate 2Q, a GaN layer (functional semiconductor layer 50) having a thickness of 300 nm was epitaxially grown. The transmittance of protective-film-attached composite substrate 2Q on which the GaN layer (functional semiconductor layer 50) had been epitaxially grown, for the light having a wavelength of 500 nm, was measured in a similar manner to Example 1-1. The measured transmittance was 60.5%. The results are summarized in Table 2.

### Comparative Example 2

Referring to Fig. 2, in a similar manner to Example 2-1, composite substrate 1 as shown in Fig. 2(A) was obtained. The transmittance of thus obtained composite substrate 1 for the light having a wavelength of 500 nm was measured in a similar manner to Example 1-1. The measured transmittance was 64.3%. On the main surface of the GaN layer (semiconductor layer) of this composite substrate 1, a GaN layer (functional semiconductor layer) having a thickness of 300 nm was epitaxially grown in a similar manner to Example 1-1. The transmittance of composite substrate 1 on which the GaN layer (functional semiconductor layer) had been epitaxially grown, for the light having a wavelength of 500 nm, was measured in a similar manner to Example 1-1. The measured transmittance was 45.0%. The results are summarized in Table 2.

**Table 2**

| | composite substrate | | | | optical transmittance | |
|---|---|---|---|---|---|---|
| | support substrate | oxide film | semiconductor layer | protective film | before epitaxial growth | after epitaxial growth |
| Example 2-1 | GaN | SrTiO₃ | GaN | GaN | 61.1 | 60.5 |
| Example 2-2 | GaN | SrTiO₃ | GaN | mullite | 61.1 | 60.5 |
| Example 2-3 | GaN | SrTiO₃ | GaN | molybdenum | 61.1 | 60.5 |
| Comparative Example 2 | GaN | SrTiO₃ | GaN | - | 64.3 | 45.0 |

As clearly seen from Table 2, in contrast to the fact that the optical transmittance of the composite substrate of Comparative Example 2 without protective film was significantly decreased from 64.3% to 45.0% by the epitaxial growth of the functional semiconductor layer, the optical transmittance of respective protective-film-attached composite substrates of Examples 2-1, 2-2, and 2-3 was caused to change from 61.1% to 60.5%, namely exhibit substantially no decrease, even by the epitaxial growth of the functional semiconductor layer. Such a decrease of the optical transmittance of the protective-film-attached composite substrates of Examples 2-1, 2-2, and 2-3 as well as the composite substrate without protective film of Comparative Example 2, resulted from devitrification due to degradation by heat and corrosion of the SrTiO₃ film (oxide film) when the functional semiconductor layer was epitaxially grown. Namely, it has been found that, in the protective-film-attached composite substrate, the SrTiO₃ film (oxide film) is protected by one of the GaN film, the mullite film, and the molybdenum film that are each a protective film, and therefore, degradation of the oxide film when the functional semiconductor layer is epitaxially grown is remarkably reduced as compared with the composite substrate without protective film, which allows a large effective region to be maintained, and accordingly, semiconductor devices having excellent characteristics can be obtained at a high yield.

### [Example 3]

### Example 3-1

Referring to Figs. 2 and 3, protective-film-attached composite substrate 2Q as shown in Fig. 2 (C) was obtained in a similar manner to Example 1-1, except that an ITO (indium tin oxide) film having a thickness of 300 nm was grown as oxide film 20 by the sputtering method. The transmittance of thus obtained protective-film-attached composite substrate 2Q for the light having a wavelength of 500 nm was measured in a similar manner to Example 1-1. The measured transmittance was 57.3%. On the main surface of the GaN layer (semiconductor layer) of this protective-film-attached composite substrate 2Q, a GaN layer (functional semiconductor layer) having a thickness of 300 nm was epitaxially grown in a similar manner to Example 1-1. The transmittance of protective-film-attached composite substrate 2Q on which the GaN layer (functional semiconductor layer) had been epitaxially grown, for the light having a wavelength of 500 nm, was measured in a similar manner to Example 1-1. The measured transmittance was 56.7%. The results are summarized in Table 3.

### Example 3-2

Referring to Fig. 2, protective-film-attached composite substrate 2Q as shown in Fig. 2(C) was obtained in a similar manner to Example 3-1 except that a mullite film having a thickness of 300 µm was formed as protective film 40 by the sputtering method. The transmittance of thus obtained protective-film-attached composite substrate 2Q for the light having a wavelength of 500 nm was measured in a similar manner to Example 1-1. The measured transmittance was 57.3%. On the main surface of the GaN layer (semiconductor layer 30a) of protective-film-attached composite substrate 2Q, a GaN layer (functional semiconductor layer 50) having a thickness of 300 nm was epitaxially grown. The transmittance of protective-film-attached composite substrate 2Q on which the GaN layer (functional semiconductor layer 50) had been epitaxially grown, for the light having a wavelength of 500 nm, was measured in a similar manner to Example 1-1. The measured transmittance was 56.7%. The results are summarized in Table 3.

### Example 3-3

Referring to Fig. 2, protective-film-attached composite substrate 2Q as shown in Fig. 2 (C) was obtained in a similar manner to Example 3-1 except that a molybdenum film having a thickness of 300 µm was formed as protective film 40 by the sputtering method. The transmittance of thus obtained protective-film-attached composite substrate 2Q for the light having a wavelength of 500 nm was measured in a similar manner to Example 1-1. The measured transmittance was 57.3%. On the main surface of the GaN layer (semiconductor layer 30a) of protective-film-attached composite substrate 2Q, a GaN layer (functional semiconductor layer 50) having a thickness of 300 nm was epitaxially grown. The transmittance of protective-film-attached composite substrate 2Q on which the GaN layer (functional semiconductor layer 50) had been epitaxially grown, for the light having a wavelength of 500 nm, was measured in a similar manner to Example 1-1. The measured transmittance was 56.7%. The results are summarized in Table 3.

### Comparative Example 3

Referring to Fig. 2, in a similar manner to Example 3-1, composite substrate 1 as shown in Fig. 2(A) was obtained. The transmittance of thus obtained composite substrate 1 for the light having a wavelength of 500 nm was measured in a similar manner to Example 1-1. The measured transmittance was 60.3%. On the main surface of the GaN layer (semiconductor layer) of this composite substrate 1, a GaN layer (functional semiconductor layer) having a thickness of 300 nm was epitaxially grown in a similar manner to Example 1-1. The transmittance of composite substrate 1 on which the GaN layer (functional semiconductor layer) had been epitaxially grown. for the light having a wavelength of 500 nm, was measured in a similar manner to Example 1-1. The measured transmittance was 42.2%. The results are summarized in Table 3.

**Table 3**

| | composite substrate | | | | optical transmittance | |
|---|---|---|---|---|---|---|
| | support substrate | oxide film | semiconductor layer | protective film | before epitaxial growth | after epitaxial growth |
| Example 3-1 | GaN | ITO | GaN | GaN | 57.3 | 56.7 |
| Example 3-2 | GaN | ITO | GaN | mullite | 57.3 | 56.7 |
| Example 3-3 | GaN | ITO | GaN | molybdenum | 57.3 | 56.7 |
| Comparative Example 3 | GaN | ITO | GaN | - | 60.3 | 42.2 |

As clearly seen from Table 3, in contrast to the fact that the optical transmittance of the composite substrate of Comparative Example 3 without protective film was significantly decreased from 60.3% to 42.2% by the epitaxial growth of the functional semiconductor layer, the optical transmittance of respective protective-film-attached composite substrates of Examples 3-1, 3-2, and 3-3 was caused to change from 57.3% to 56.7%, namely exhibit substantially no decrease, even by the epitaxial growth of the functional semiconductor layer. Such a decrease of the optical transmittance of the protective-film-attached composite substrates of Examples 3-1, 3-2, and 3-3 as well as the composite substrate without protective film of Comparative Example 3, resulted from devitrification due to degradation by heat and corrosion of the ITO film (oxide film) when the functional semiconductor layer was epitaxially grown. Namely, it has been found that, in the protective-film-attached composite substrate, the ITO film (oxide film) is protected by one of the GaN film, the mullite film, and the molybdenum film that are each a protective film, and therefore, degradation of the oxide film when the functional semiconductor layer is epitaxially grown is remarkably reduced as compared with the composite substrate without protective film, which allows a large effective region to be maintained, and accordingly, semiconductor devices having excellent characteristics can be obtained at a high yield.

### [Example 4]

### Example 4-1

Referring to Figs. 2 and 3, protective-film-attached composite substrate 2Q as shown in Fig. 2 (C) was obtained in a similar manner to Example 1-1, except that an ATO (antimony tin oxide) film having a thickness of 300 nm was grown as oxide film 20 by the sputtering method. The transmittance of thus obtained protective-film-attached composite substrate 2Q for the light having a wavelength of 500 nm was measured in a similar manner to Example 1-1. The measured transmittance was 57.8%. On the main surface of the GaN layer (semiconductor layer) of this protective-film-attached composite substrate 2Q, a GaN layer (functional semiconductor layer) having a thickness of 300 nm was epitaxially grown in a similar manner to Example 1-1. The transmittance of protective-film-attached composite substrate 2Q on which the GaN layer (functional semiconductor layer) had been epitaxially grown, for the light having a wavelength of 500 nm, was measured in a similar manner to Example 1-1. The measured transmittance was 57.2%. The results are summarized in Table 4.

### Example 4-2

Referring to Fig. 2, protective-film-attached composite substrate 2Q as shown in Fig. 2 (C) was obtained in a similar manner to Example 4-1 except that a mullite film having a thickness of 300 µm was formed as protective film 40 by the sputtering method. The transmittance of thus obtained protective-film-attached composite substrate 2Q for the light having a wavelength of 500 nm was measured in a similar manner to Example 1-1. The measured transmittance was 57.8%. On the main surface of the GaN layer (semiconductor layer 30a) of protective-film-attached composite substrate 2Q, a GaN layer (functional semiconductor layer 50) having a thickness of 300 nm was epitaxially grown. The transmittance of protective-film-attached composite substrate 2Q on which the GaN layer (functional semiconductor layer 50) had been epitaxially grown, for the light having a wavelength of 500 nm, was measured in a similar manner to Example 1-1. The measured transmittance was 57.2%. The results are summarized in Table 4.

### Example 4-3

Referring to Fig. 2, protective-film-attached composite substrate 2Q as shown in Fig. 2 (C) was obtained in a similar manner to Example 4-1 except that a molybdenum film having a thickness of 300 µm was formed as protective film 40 by the sputtering method. The transmittance of thus obtained protective-film-attached composite substrate 2Q for the light having a wavelength of 500 nm was measured in a similar manner to Example 1-1. The measured transmittance was 57.8%. On the main surface of the GaN layer (semiconductor layer 30a) of protective-film-attached composite substrate 2Q, a GaN layer (functional semiconductor layer 50) having a thickness of 300 nm was epitaxially grown. The transmittance of protective-film-attached composite substrate 2Q on which the GaN layer (functional semiconductor layer 50) had been epitaxially grown, for the light having a wavelength of 500 nm, was measured in a similar manner to Example 1-1. The measured transmittance was 57.2%. The results are summarized in Table 4.

### Comparative Example 4

Referring to Fig. 2, in a similar manner to Example 4-1, composite substrate 1 as shown in Fig. 2 (A) was obtained. The transmittance of thus obtained composite substrate 1 for the light having a wavelength of 500 nm was measured in a similar manner to Example 1-1. The measured transmittance was 60.8%. On the main surface of the GaN layer (semiconductor layer) of this composite substrate 1, a GaN layer (functional semiconductor layer) having a thickness of 300 nm was epitaxially grown in a similar manner to Example 1-1. The transmittance of composite substrate 1 on which the GaN layer (functional semiconductor layer) had been epitaxially grown, for the light having a wavelength of 500 nm, was measured in a similar manner to Example 1-1. The measured transmittance was 42.6%. The results are summarized in Table 4.

**Table 4**

| | composite substrate | | | | optical transmittance | |
|---|---|---|---|---|---|---|
| | support substrate | oxide film | semiconductor layer | protective film | before epitaxial growth | after epitaxial growth |
| Example 4-1 | GaN | ATO | GaN | GaN | 57.8 | 57.2 |
| Example 4-2 | GaN | ATO | GaN | mullite | 57.8 | 57.2 |
| Example 4-3 | GaN | ATO | GaN | molybdenum | 57.8 | 57.2 |
| Comparative Example 4 | GaN | ATO | GaN | - | 60.8 | 42.6 |

As clearly seen from Table 4, in contrast to the fact that the optical transmittance of the composite substrate of Comparative Example 4 without protective film was significantly decreased from 60.8% to 42.6% by the epitaxial growth of the functional semiconductor layer, the optical transmittance of respective protective-film-attached composite substrates of Examples 4-1, 4-2, and 4-3 was caused to change from 57.8% to 57.2%, namely exhibit substantially no decrease, even by the epitaxial growth of the functional semiconductor layer. Such a decrease of the optical transmittance of the protective-film-attached composite substrates of Examples 4-1, 4-2, and 4-3 as well as the composite substrate without protective film of Comparative Example 4, resulted from devitrification due to degradation by heat and corrosion of the ATO film (oxide film) when the functional semiconductor layer was epitaxially grown. Namely, it has been found that, in the protective-film-attached composite substrate, the ATO film (oxide film) is protected by one of the GaN film, the mullite film, and the molybdenum film that are each a protective film, and therefore, degradation of the oxide film when the functional semiconductor layer is epitaxially grown is remarkably reduced as compared with the composite substrate without protective film, which allows a large effective region to be maintained, and accordingly, semiconductor devices having excellent characteristics can be obtained at a high yield.

### [Example 5]

### Example 5-1

Referring to Figs. 2 and 3, protective-film-attached composite substrate 2Q as shown in Fig. 2(C) was obtained in a similar manner to Example 1-1, except that a ZnO film having a thickness of 300 nm was grown as oxide film 20 by the sputtering method. The transmittance of thus obtained protective-film-attached composite substrate 2Q for the light having a wavelength of 500 nm was measured in a similar manner to Example 1-1. The measured transmittance was 57.1%. On the main surface of the GaN layer (semiconductor layer) of this protective-film-attached composite substrate 2Q, a GaN layer (functional semiconductor layer) having a thickness of 300 nm was epitaxially grown in a similar manner to Example 1-1. The transmittance of protective-film-attached composite substrate 2Q on which the GaN layer (functional semiconductor layer) had been epitaxially grown, for the light having a wavelength of 500 nm, was measured in a similar manner to Example 1-1. The measured transmittance was 56.5%. The results are summarized in Table 5.

### Example 5-2

Referring to Fig. 2, protective-film-attached composite substrate 2Q as shown in Fig. 2 (C) was obtained in a similar manner to Example 5-1 except that a mullite film having a thickness of 300 µm was formed as protective film 40 by the sputtering method. The transmittance of thus obtained protective-film-attached composite substrate 2Q for the light having a wavelength of 500 nm was measured in a similar manner to Example 1-1. The measured transmittance was 57.1%. On the main surface of the GaN layer (semiconductor layer 30a) of protective-film-attached composite substrate 2Q, a GaN layer (functional semiconductor layer 50) having a thickness of 300 nm was epitaxially grown. The transmittance of protective-film-attached composite substrate 2Q on which the GaN layer (functional semiconductor layer 50) had been epitaxially grown, for the light having a wavelength of 500 nm, was measured in a similar manner to Example 1-1. The measured transmittance was 56.5%. The results are summarized in Table 5.

### Example 5-3

Referring to Fig. 2, protective-film-attached composite substrate 2Q as shown in Fig. 2(C) was obtained in a similar manner to Example 5-1 except that a molybdenum film having a thickness of 300 µm was formed as protective film 40 by the sputtering method. The transmittance of thus obtained protective-film-attached composite substrate 2Q for the light having a wavelength of 500 nm was measured in a similar manner to Example 1-1. The measured transmittance was 57.1% On the main surface of the GaN layer (semiconductor layer 30a) of protective-film-attached composite substrate 2Q, a GaN layer (functional semiconductor layer 50) having a thickness of 300 nm was epitaxially grown The transmittance of protective-film-attached composite substrate 2Q on which the GaN layer (functional semiconductor layer 50) had been epitaxially grown, for the light having a wavelength of 500 nm, was measured in a similar manner to Example 1-1. The measured transmittance was 56.5%. The results are summarized in Table 5

### Comparative Example 5

Referring to Fig. 2, in a similar manner to Example 5-1, composite substrate 1 as shown in Fig. 2 (A) was obtained. The transmittance of thus obtained composite substrate 1 for the light having a wavelength of 500 nm was measured in a similar manner to Example 1-1. The measured transmittance was 60 1 % On the main surface of the GaN layer (semiconductor layer) of this composite substrate 1, a GaN layer (functional semiconductor layer) having a thickness of 300 nm was epitaxially grown in a similar manner to Example 1-1. The transmittance of composite substrate 1 on which the GaN layer (functional semiconductor layer) had been epitaxially grown, for the light having a wavelength of 500 nm, was measured in a similar manner to Example 1-1. The measured transmittance was 42 1 % The results are summarized in Table 5

**Table 5**

| | composite substrate | | | | optical transmittance | |
|---|---|---|---|---|---|---|
| | support substrate | oxide film | semiconductor layer | protective film | before epitaxial growth | after epitaxial growth |
| Example 5-1 | GaN | ZnO | GaN | GaN | 57.1 | 56.5 |
| Example 5-2 | GaN | ZnO | GaN | mullite | 57.1 | 56.5 |
| Example 5-3 | GaN | ZnO | GaN | molybdenum | 57.1 | 56.5 |
| Comparative Example 5 | GaN | ZnO | GaN | - | 60.1 | 42.1 |

As clearly seen from Table 5, in contrast to the fact that the optical transmittance of the composite substrate of Comparative Example 5 without protective film was significantly decreased from 60.1% to 42.1% by the epitaxial growth of the functional semiconductor layer, the optical transmittance of respective protective-film-attached composite substrates of Examples 5-1, 5-2, and 5-3 was caused to change from 57.1% to 56.5%, namely exhibit substantially no decrease, even by the epitaxial growth of the functional semiconductor layer. Such a decrease of the optical transmittance of the protective-film-attached composite substrates of Examples 5-1, 5-2, and 5-3 as well as the composite substrate without protective film of Comparative Example 5, resulted from devitrification due to degradation by heat and corrosion of the ZnO film (oxide film) when the functional semiconductor layer was epitaxially grown. Namely, it has been found that, in the protective-film-attached composite substrate, the ZnO film (oxide film) is protected by one of the GaN film, the mullite film, and the molybdenum film that are each a protective film, and therefore, degradation of the oxide film when the functional semiconductor layer is epitaxially grown is remarkably reduced as compared with the composite substrate without protective film, which allows a large effective region to be maintained, and accordingly, semiconductor devices having excellent characteristics can be obtained at a high yield.

### [Example 6]

### Example 6-1

Referring to Figs. 2 and 3, protective-film-attached composite substrate 2Q as shown in Fig. 2(C) was obtained in a similar manner to Example 1-1, except that a Ga₂O₃ film having a thickness of 300 nm was grown as oxide film 20 by the sputtering method. The transmittance of thus obtained protective-film-attached composite substrate 2Q for the light having a wavelength of 500 nm was measured in a similar manner to Example 1-1. The measured transmittance was 54.7%. On the main surface of the GaN layer (semiconductor layer) of this protective-film-attached composite substrate 2Q, a GaN layer (functional semiconductor layer) having a thickness of 300 nm was epitaxially grown in a similar manner to Example 1-1. The transmittance of protective-film-attached composite substrate 2Q on which the GaN layer (functional semiconductor layer) had been epitaxially grown, for the light having a wavelength of 500 nm, was measured in a similar manner to Example 1-1. The measured transmittance was 54.2%. The results are summarized in Table 6.

### Example 6-2

Referring to Fig. 2, protective-film-attached composite substrate 2Q as shown in Fig. 2 (C) was obtained in a similar manner to Example 6-1 except that a mullite film having a thickness of 300 µm was formed as protective film 40 by the sputtering method. The transmittance of thus obtained protective-film-attached composite substrate 2Q for the light having a wavelength of 500 nm was measured in a similar manner to Example 1-1. The measured transmittance was 54.7%. On the main surface of the GaN layer (semiconductor layer 30a) of protective-film-attached composite substrate 2Q, a GaN layer (functional semiconductor layer 50) having a thickness of 300 nm was epitaxially grown. The transmittance of protective-film-attached composite substrate 2Q on which the GaN layer (functional semiconductor layer 50) had been epitaxially grown, for the light having a wavelength of 500 nm, was measured in a similar manner to Example 1-1. The measured transmittance was 54.2%. The results are summarized in Table 6.

### Example 6-3

Referring to Fig. 2, protective-film-attached composite substrate 2Q as shown in Fig. 2 (C) was obtained in a similar manner to Example 6-1 except that a molybdenum film having a thickness of 300 µm was formed as protective film 40 by the sputtering method. The transmittance of thus obtained protective-film-attached composite substrate 2Q for the light having a wavelength of 500 nm was measured in a similar manner to Example 1-1. The measured transmittance was 54.7%. On the main surface of the GaN layer (semiconductor layer 30a) of protective-film-attached composite substrate 2Q, a GaN layer (functional semiconductor layer 50) having a thickness of 300 nm was epitaxially grown. The transmittance of protective-film-attached composite substrate 2Q on which the GaN layer (functional semiconductor layer 50) had been epitaxially grown, for the light having a wavelength of 500 nm, was measured in a similar manner to Example 1-1. The measured transmittance was 54 2% The results are summarized in Table 6

### Comparative Example 6

Referring to Fig. 2, in a similar manner to Example 6-1, composite substrate 1 as shown in Fig 2 (A) was obtained The transmittance of thus obtained composite substrate 1 for the light having a wavelength of 500 nm was measured in a similar manner to Example 1-1. The measured transmittance was 57 6% On the main surface of the GaN layer (semiconductor layer) of this composite substrate 1, a GaN layer (functional semiconductor layer) having a thickness of 300 nm was epitaxially grown in a similar manner to Example 1-1. The transmittance of composite substrate I on which the GaN layer (functional semiconductor layer) had been epitaxially grown, for the light having a wavelength of 500 nm, was measured in a similar manner to Example 1-1. The measured transmittance was 51.8%. The results are summanzed in Table 6

**Table 6**

| | composite substrate | | | | optical transmittance | |
|---|---|---|---|---|---|---|
| | support substrate | oxide film | semiconductor layer | protective film | before epitaxial growth | after epitaxial growth |
| Example 6-1 | GaN | Ga₂O₃ | GaN | GaN | 54.7 | 54.2 |
| Example 6-2 | GaN | Ga₂O₃ | GaN | mullite | 54.7 | 54.2 |
| Example 6-3 | GaN | Ga₂O₃ | GaN | molybdenum | 54.7 | 54.2 |
| Comparative Example 6 | GaN | Ga₂O₃ | GaN | - | 57.6 | 51.8 |

As clearly seen from Table 6, in contrast to the fact that the optical transmittance of the composite substrate of Comparative Example 6 without protective film was significantly decreased from 57.6% to 51.8% by the epitaxial growth of the functional semiconductor layer, the optical transmittance of respective e protective-film-attached composite substrates of Examples 6-1, 6-2, and 6-3 was caused to change from 54.7% to 54.2%, namely exhibit substantially no decrease, even by the epitaxial growth of the functional semiconductor layer. Such a decrease of the optical transmittance of the protective-film-attached composite substrates of Examples 6-1, 6-2, and 6-3 as well as the composite substrate without protective film of Comparative Example 6, resulted from devitrification due to degradation by heat and corrosion of the Ga₂O₃ film when the functional semiconductor layer was epitaxially grown. Namely, it has been found that, in the protective-film-attached composite substrate, the Ga₂O₃ film is protected by one of the GaN film, the mullite film, and the molybdenum film that are each a protective film, and therefore, degradation of the oxide film when the functional semiconductor layer is epitaxially grown is remarkably reduced as compared with the composite substrate without protective film, which allows a large effective region to be maintained, and accordingly, semiconductor devices having excellent characteristics can be obtained at a high yield.

It should be construed that the embodiments and examples herein disclosed should be construed as being given by way of illustration in all respects, not by way of limitation. It is intended that the scope of the present invention is defined by claims, not by the description above, and encompasses all modifications and variations equivalent in meaning and scope to the claims.

### REFERENCE SIGNS LIST

1 composite substrate; 2P, 2Q protective-film-attached composite substrate; 3 semiconductor device; 10 support substrate; 20 oxide film; 20s, 20t non-covered portion; 30 semiconductor substrate; 30a semiconductor layer; 30b remaining semiconductor substrate; 30i ion implantation region; 40 protective film; 50 functional semiconductor layer

## Claims

1. A protective-film-attached composite substrate comprising: a support substrate (10); an oxide film (20) disposed on said support substrate (10); a semiconductor layer (30a) disposed on said oxide film (20); and a protective film (40) protecting said oxide film (20) by covering a portion (20s, 20t) that is a part of said oxide film (20) and covered with none of said support substrate (10) and said semiconductor layer (30a).

2. The protective-film-attached composite substrate according to claim 1, wherein said oxide film (20) is at least one selected from the group consisting of TiO₂ film, SrTiO₃ film, indium tin oxide film, antimony tin oxide film, ZnO film, and Ga₂O₃ film.

3. The protective-film-attached composite substrate according to claim 2, wherein at least one of said support substrate (10) and said semiconductor layer (30a) is formed of a group III nitride.

4. The protective-film-attached composite substrate according to claim 1, wherein at least one of said support substrate (10) and said semiconductor layer (30a) is formed of a group III nitride.

5. A method of manufacturing a semiconductor device comprising the steps of:
preparing the protective-film-attached composite substrate (2Q) recited in claim 1; and
epitaxially growing, on said semiconductor layer (30a) of said protective-film-attached composite substrate (2Q), at least one functional semiconductor layer (50) causing an essential function of a semiconductor device (3) to be performed.
